# EUROPEAN PATENT SPECIFICATION

(11) **EP 0 541 823 B1**
(45) Date of publication and mention of the grant of the patent: **05.03.1997**
(21) Application number: 92911023.7
(22) Date of filing: 02.06.1992
(51) Int. Cl.: F28D 15/02, H01L 23/24

(54) **HEAT PIPE CONNECTOR, ELECTRONIC DEVICE AND HEAT RADIATING FAN HAVING SAID PIPE**
VERBINDUNGSSTÜCK FÜR WÄRMEROHR, ELEKTRONISCHE VORRICHTUNG UND STRAHLENDER HEIZKÖRPER MIT DERARTIGEM ROHR
RACCORD POUR TUBE DE TRANSFERT DE CHALEUR, DISPOSITIF ELECTRONIQUE ET RADIATEUR A AILETTES EQUIPES D'UN TEL TUBE

(30) Priority: 05.06.1991 JP 134425/91
(43) Date of publication of application: 19.05.1993
(73) Proprietor: FUJITSU LIMITED, Kawasaki-shi, Kanagawa 211 (JP)
(72) Inventor: YAMAJI, Hiroshi, Fujitsu Limited, Kawasaki-shi,Kanagawa 211 (JP); HONGOH, Tomoyuki, Fujitsu Limited, Kawasaki-shi,Kanagawa 211 (JP); SATO, Takashi, Nakahara-ku Kawasaki-shi Kanagawa 211 (JP); TAKAHASHI, Tsutomu, Fujitsu Limited, Nakahara-ku, Kawasaki-shi, Kanagawa 211 (JP); MAGOME, Riichi, Fujitsu Limited, 1015,Kamikodanaka, Kawasaki-shi, Kanagawa 211 (JP)
(74) Representative: Schmidt-Evers, Jürgen, Dipl.-Ing.
(86) International application number: JP9200713
(87) International publication number: WO9221927

(56) References cited:
- JP-A-53 001 823
- JP-A-60 226 966
- JP-A-63 070 447
- JP-B-58 047 587
- JP-U- 2 045 694
- PATENT ABSTRACTS OF JAPAN vol. 14, no. 411 (E-973) 5 September 1990 & JP-A-02 155 296 (FUJITSU LTD) 14 June 1990
- PATENT ABSTRACTS OF JAPAN vol. 11, no. 224 (E-525) 21 July 1987 & JP-A-62 042 550 (FUJITSU LTD) 24 February 1987

## Description

### FIELD OF THE INVENTION

The present invention pertains to a heat pipe connector as well as to an electronic apparatus and radiating fins having such a connector, and more particularly to a heat pipe connector for connecting a heat pipe to a radiating portion or to a heat-generating portion as well as to an electronic apparatus and radiating fins having such a connector.

### BACKGROUND ART

Among methods for conducting heat generated by electronic parts to radiating fins is a method using a heat pipe. In this method, it is necessary for the heat pipe to be connected to the electronic parts and to the radiating fins. Generally, the electronic parts are mounted by inserting them in the form of a printed board composite from the front of a shelf of an electronic apparatus. For this reason, it is desirable that the heat pipe be connected in such a manner as to allow the mounting of the printed board composite.

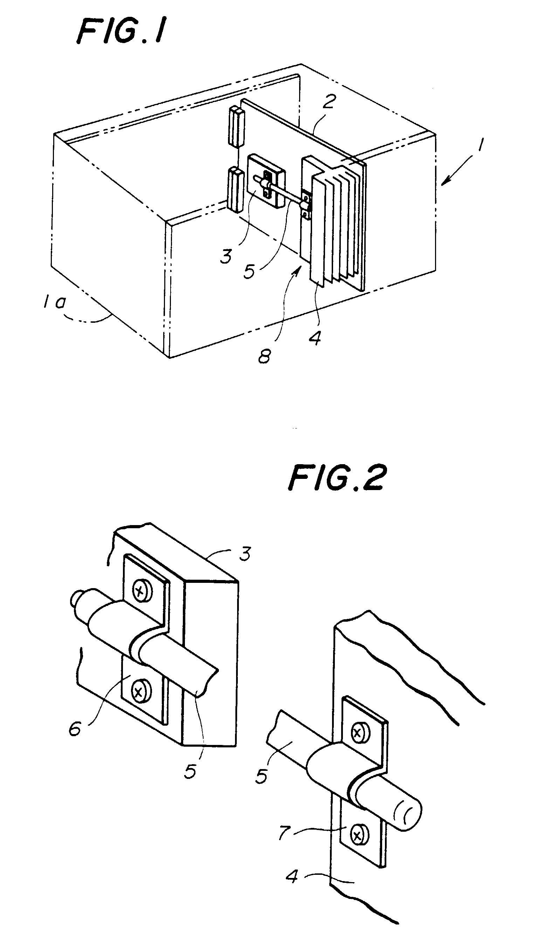

FIG.1 illustrates an example of the conventional electronic apparatus. In the figure, a plurality of printed board composites 8 are inserted and mounted in a shelf la of an electronic apparatus 1. The printed board composite 8 comprises: a printed board 2; an electronic part 3 and radiating fins 4 both provided on the printed board; and a heat pipe 5.

As shown enlarged in FIG.2, the heat pipe 5 is fixed on the electronic part 3 and the radiating fins 4 by means of respective hardwares 6, 7. This construction, in which the heat pipe 5 is fixed on the electronic part 3 and the radiating fins 4, has a disadvantage in that the only feasible configuration for the radiating fins 4 is the one in which the radiating fins are fitted to the printed board 2, and the configuration where the radiating fins 4 are fitted to the shelf la not being achievable. The configuration in which the radiating fins 4 are fitted to the printed board 2 is unfavorable in terms of radiating efficiency because the radiating fins 4 are housed inside the shelf la. Another problem is that the printed board composites 8 become heavy when the radiating fins 4 are mounted thereto.

### DISCLOSURE OF THE INVENTION

From the prior art document PATENT ABSTRACTS OF JAPAN, vol. 14, no. 411 (E-973), September 5, 1990 & JP-A-62 042 550 (FUJITSU LTD), February 24, 1987 a heat pipe connector is known with a housing in the form of a clamping device with a hole into which a heat pipe is inserted.

The object of the present invention is to provide a novel and useful heat pipe connector as well as an electronic apparatus and a radiator fin structure having such connector in which the above-described disadvantages are eliminated.

Another object of the present invention is to provide a heat pipe connector comprising a housing in the form of a clamping device with a hole into which a heat pipe is inserted.

According to the invention, the heat pipe connector comprises a housing which has a large opening and a small opening which connect to form the hole being generally shaped like a quadrangular pyramid, a plurality of clamp pieces which have a shape corresponding to the shape of the hole when combined, the clamp pieces being combined and fit within the hole and forming a heat pipe insertion opening at a central part thereof, the heat pipe insertion opening being adapted to receive the heat pipe, and a plurality of springs for urging the clamp pieces towards the small opening of the hole by spring forces.

According to the present invention, an end of the heat pipe thus inserted can be connected to a radiating portion and/or a heat-generating portion, thus providing excellent heat convection in the connection portion.

Furthermore, according to the invention, the above-described heat pipe connector of the invention is used for an electronic apparatus, the electronic apparatus comprising a housing having openings, at least one printed wiring-board assembly inserted through one of the openings in the housing and mounted in the housing, a back cover for covering another of the openings in the housing, and a heat pipe connecting the printed wiring-board assembly and the back cover, wherein at least one heat pipe connector is detachably connected to one end of the heat pipe, the heat pipe connector being fixed to at least one of the printed wiring-board assembly and the back cover.

According to the present invention, it is possible to radiate heat of the heat-generating portion on the printed board from the back cover when the printed wiring-board assembly is mounted inside the housing by inserting the assembly through the front of the housing. Hence, the radiating efficiency of the present invention is better than that of the conventional art. Another advantage of the present invention is that electromagnetic shielding behaviour is improved because there is no need to provide a vent hole on a front cover of the electronic apparatus. Furthermore, since it is not necessary to provide radiating fins on the printed wiring-board assembly, the printed wiring-board assembly can be made smaller and lighter than that in the conventional art, and the number of electronic parts that can be fitted on the printed board is larger than the number than can be conventionally fitted.

It is also found that a configuration in which the heat pipe is not fixed on the printed wiring-board assembly makes it easy to handle the printed wiring-board assembly. Similary, a configuration in which the heat pipe is not fixed to the back cover facilitates easy handling of the back cover.

Moreover, according to the invention, the above-described heat pipe connector of the invention is used for another electronic apparatus, the electronic apparatus comprising a housing, a heat pipe having one end connected to a heat pipe generating portion within the housing and another end projecting from the housing, and a radiator fin structure having the heat pipe connector which is detachably connected to the other end of the heat pipe.

Finally, according to the invention, the above-described heat pipe connector of the invention is used in a radiator fin structure, the radiator fin structure comprising a fin member having a plurality of fins and the heat pipe connector being fixed to the fin member and detachably connected to one end of a heat pipe.

According to the present invention, the radiating efficiency of an electronic apparatus can be improved by radiating fins having a simple configuration.

Other objects and further features of the present invention will become apparent from the following detailed description when read in conjunction with the accompanying drawings.

### BRIEF DESCRIPTION OF THE DRAWINGS

FIG.1 is a perspective view illustrating an example of the conventional electronic apparatus;
FIG.2 is an enlarged perspective view illustrating the connection portion of the heat pipe of FIG.1;
FIG.3 is an exploded perspective view illustrating an embodiment of the heat pipe connector according to the present invention;
FIG.4 is a cross-sectional view of the heat pipe connector of FIG.3;
FIG.5 is a back view of the housing of FIG.3 viewed from the large opening therein;
FIG.6 is a cross-sectional view taken along the line VI - VI of FIG.5;
FIG.7 is a perspective view illustrating a clamp piece of FIG.3;
FIG.8 is a cross-sectional view taken along the line VIII - VIII of FIG.4;
FIG.9 illustrates how the heat pipe is connected to the connector;
FIG.10 illustrates the state in which the heat pipe is connected to the heat pipe connector;
FIG.ll is a back view of FIG.10 viewed from the large opening in the housing, with a spring seat being removed;
FIG.12 is a cross-sectional view taken along the line of XII - XII of FIG.10;
FIG.13 illustrates the first embodiment of the electronic apparatus according to the present invention;
FIG.14 illustrates the state of the first embodiment of the electronic apparatus in which state the printed board composite is mounted;
FIG.15 illustrates the second embodiment of the electronic apparatus of the present invention;
FIG.16 illustrates the third embodiment of the electronic apparatus of the present invention;
FIG.17 illustrates the fourth embodiment of the electronic apparatus of the present invention;
FIG.18 is a cross-sectional view illustrating an embodiment of the radiating fins according to the present invention;
FIG.19 is a perspective view of the electronic apparatus to which the radiating fins of FIG.18 can be applied;
FIG.20 is a perspective view illustrating the electronic apparatus of FIG.19 placed sideways and used in that condition;
FIG.21 is a perspective view illustrating the electronic apparatus of FIG.19 placed on end and used in that condition;
FIG.22 is a perspective view illustrating the tool used for removing the heat pipe connector from the heat pipe;
FIG.23 illustrates a removal operation of the heat pipe connector using the tool; and
FIG.24 illustrates how the edge of the tool and the clamp piece of the heat pipe connector contact each other.

### BEST MODE OF CARRYING OUT THE INVENTION

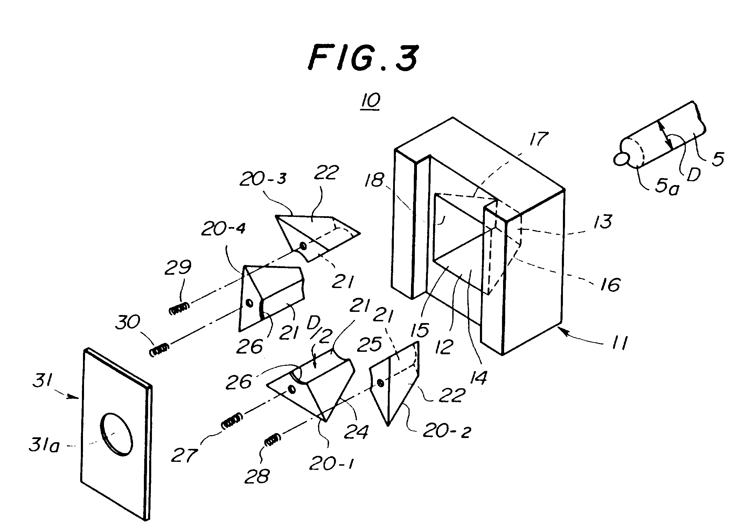

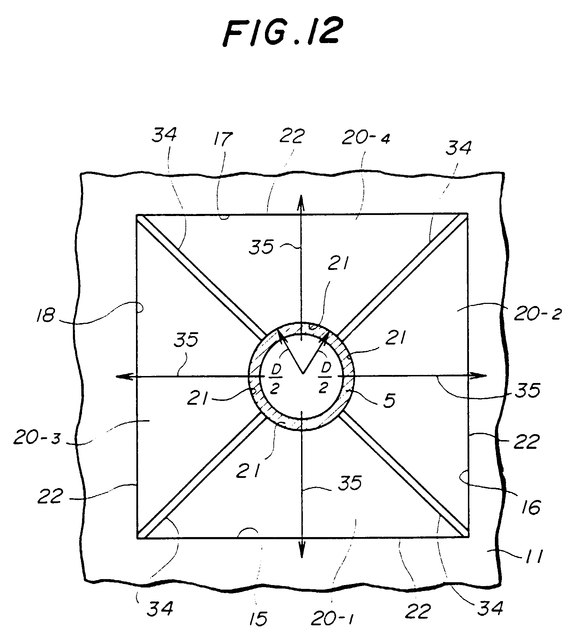

First, an embodiment of the heat pipe connector according to the present invention will be described with reference to FIGS.3 - 12.

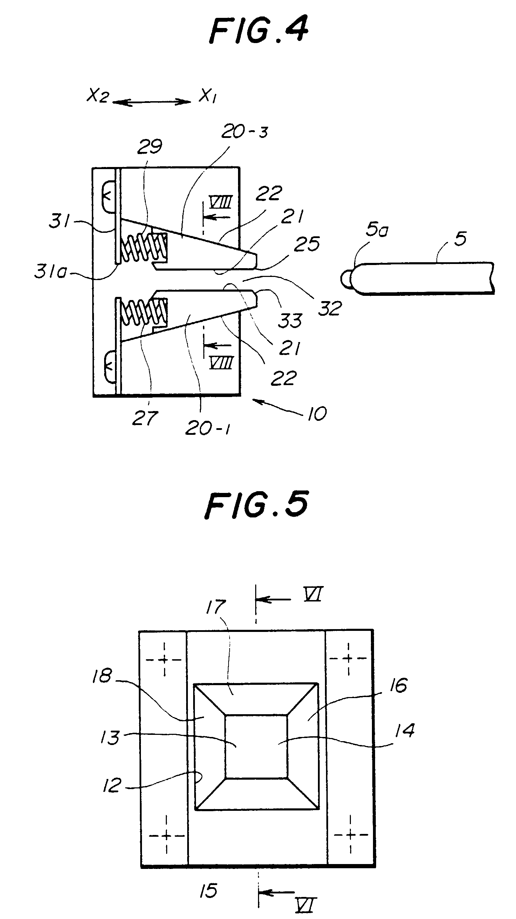

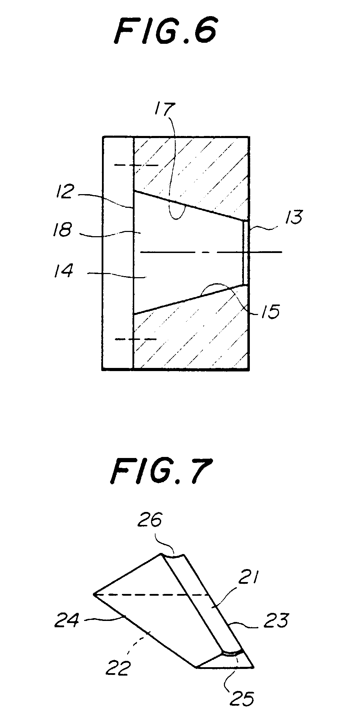

FIGS.3 and 4 illustrate the heat pipe connector according to the present invention. In the figures, a heat pipe connector 10 comprises an aluminum housing 11; and a hole 14 shaped like a quadrangular pyramid with a large opening 12 and a small opening 13 is formed in the housing 11, as shown in FIGS.5 and 6. Lateral surfaces 15 - 18 of the hole 14 are inclining planes.

Clamp pieces 20₋₁ - 20₋₄ are combined to form a quadrangular pyramid body that corresponds to the hole 14, and a hole is drilled in the center of the combined pieces, which hole has a diameter corresponding to a diameter D of a heat pipe 5. This body is severed diagonally crosswise, the severed surfaces thereof being ground to a predetermined degree, and the resultant clamp pieces having the same shape. As shown in FIG.7, each of the clamp pieces 20₋₁ - 20₋₄ has a circular section 21 having a radius of D/2 on one side thereof, a flat surface 22 corresponding to one of the lateral surfaces 15 - 18 on the other side thereof, and slopes 23, 24 on both lateral sides thereof. Both longitudinal ends of the circular section 21 are chamfered to create slopes 25, 26.

The clamp pieces 20₋₁ - 20₋₄ are fitted into the hole 14 of the housing 11, and are independently energized by means of compression coil springs 27 - 30 in the X₁ direction shown by an arrow. Spring seat plates 31, having, in the center, a hole 31a which accepts a heat pipe 21, are screwed to the back of the housing 11 in such a manner as to block the large opening 12. Each of the clamp pieces 20₋₁ - 20₋₄ is independently urged by means of the respective springs 27 - 30 in the X₁ direction shown by the arrow, and, as shown in FIG.4, partially projects from the small opening 13. As a result, the clamp pieces are fitted into the hole 14 in a converging manner so that they are drawn to one another toward their respective narrower ends.

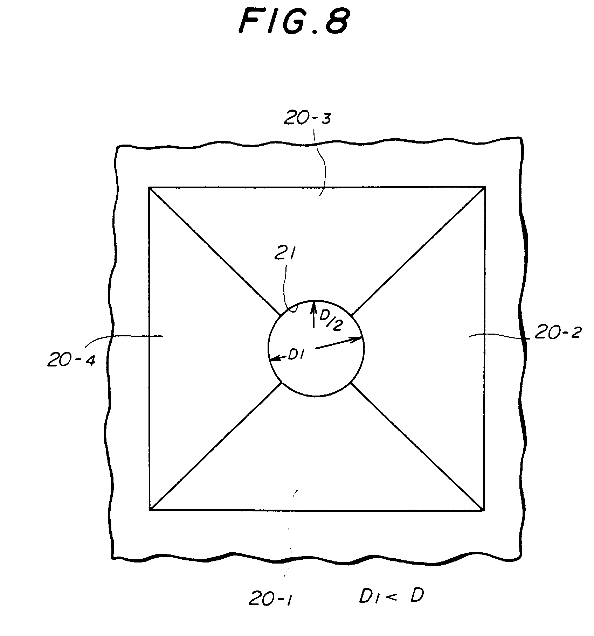

As shown in FIG.8, a diameter D₁ of a heat pipe insertion opening 32 formed by the circular section 21 of each of the clamp pieces 20₋₁ - 20₋₄ is such that D₁ < D. The heat pipe insertion opening 32 is somewhat circular when viewed from top. The mouth of the hole 32, near the small opening 13 thereof, is turned into a taper portion 33 due to the chamfer slope 25 provided thereon.

A description will be given now of how the heat pipe 5 is connected to the connector 10.

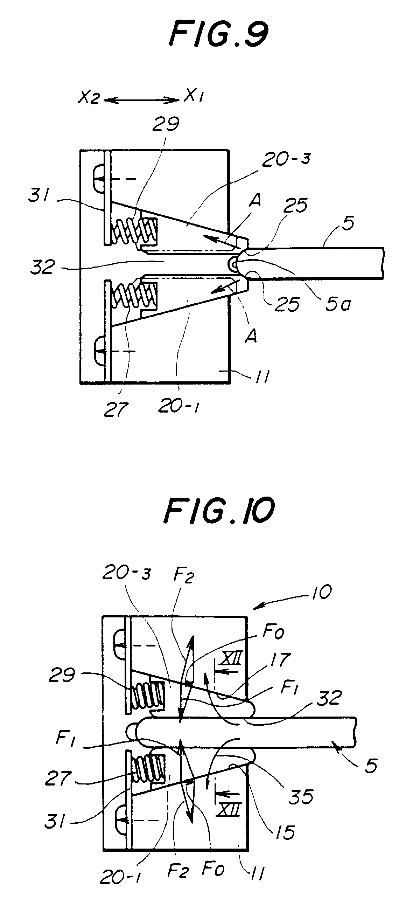

The heat pipe 5 is connected to the connector 10 when the heat pipe 5 is thrust in the direction X₂ shown by an arrow and forced into the hole 32 from the side of the small opening 13 of the housing 11. An end 5a of the heat pipe 5 is generally semi-spherical. As shown in FIG.9, the semi-spherical end 5a of the heat pipe 5 engages with the taper portion 33, and therefore comes in contact with the chamfered slope 25 and presses the same. As indicated by an arrow A, forces parallel to the slopes 15 - 18 of the hole 14 are exerted on the clamp pieces 20₋₁ - 20₋₄, respectively.

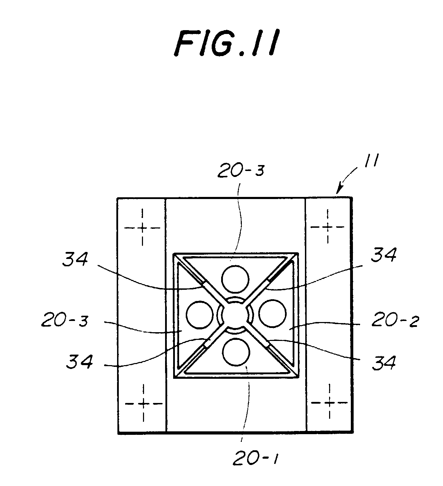

In consequence of this, as shown by an alternating long and two short dashes line, the clamp pieces 20₋₁ - 20₋₄ are driven in the X₂ direction shown by the arrow by the forces parallel to the slopes 15 - 18 of the hole 14, at the same time as the springs 27 - 30 are respectively compressed, with the result that the hole 32 becomes larger. This way, the heat pipe 5 can be inserted in the hole 32, and connected to the connector 10, as shown in FIGS.10 and 11.

A description will next be given of the connection state.

Because the clamp pieces 20₋₁ - 20₋₄ are displaced in the X₂ direction shown by the arrow, gaps 34 are created between the slopes 23 and 24 of the adjacent the clamp pieces 20₋₁ - 20₋₄ as shown in FIG.ll, and thus the clamps 20₋₁ - 20₋₄ become separate and independent. The clamp pieces 20₋₁ - 20₋₄ thus separated are independently urged by a spring force F₀ of the springs 27 - 30 in the X₁ direction shown by the arrow. The clamp pieces 20₋₁ - 20₋₄ are guided by the slopes 15 - 18 that are in contact with the surface 22. Therefore, a force F₁ is generated and exerted in a direction along which the clamp pieces 20₋₁ - 20₋₄ are drawn to one another toward their narrower ends, in other words, in such a manner that the hole 32 shrinks in the radial direction, resulting in the clamp pieces 20₋₁ - 20₋₄ clamping the heat pipe 5, and the circular sections 21 being pressed against the entire circumferential surface of the heat pipe 5.

Since the radius of the circular section 21 is configured to be D/2, all of the surfaces of the circular sections 21 are in tight contact with the outer circumference of the heat pipe 5. The clamp pieces 20₋₁- 20₋₄ are pressed, by a force F₂, against the lateral surfaces 15 - 18 corresponding to the respective flat surfaces 22 by means of the springs 27 - 30. Since the lateral surfaces 15 - 18 are flat, all of the flat surfaces 22 are placed in tight contact with the respective lateral surfaces 15 - 18. It is thus ensured that sufficiently large contact areas are provided between the heat pipe 5 and each of the clamp pieces 20₋₁ - 20₋₄, and between the housing 11 and each of the clamp pieces 20₋₁ - 20₋₄.

As a result of this, heat from the heat pipe 5 is conducted to the clamp pieces 20₋₁ - 20₋₄ efficiently, as shown by an arrow 35, and also from the clamp pieces 20₋₁ - 20₋₄ to the housing 11 efficiently.

A description will now be given of how the heat pipe is disconnected.

In FIG.10, the heat pipe 5 is pulled forcefully in the X₁ direction. This causes the heat pipe 5 to be drawn out of the hole 32 to be disconnected from the connector 10.

In an alternative configuration the hole in the housing 11 is shaped like a triangular pyramid, into which hole three clamp pieces are fitted. Also, the hole in the housing 11 can be shaped like a circular cone, into which hole a plurality of clamp pieces are fitted. That is, the shape of the hole in the housing 11 and the number of clamp pieces are not limited to those in the described embodiment. The only requirement regarding the number of clamp pieces is that there be more than two.

A description will next be given of embodiments of the electronic apparatus of the present invention to which apparatus the heat pipe connector 10 of the above configuration is applied.

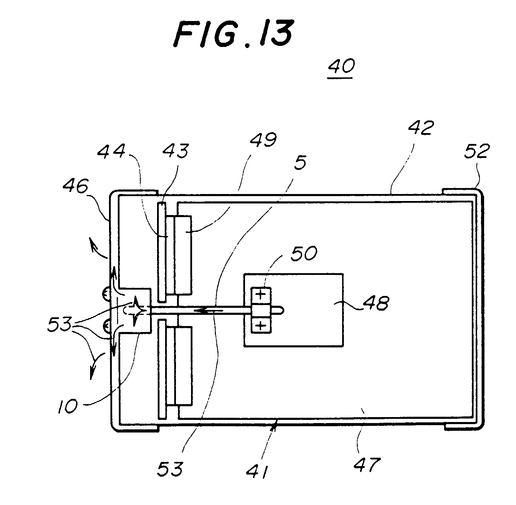

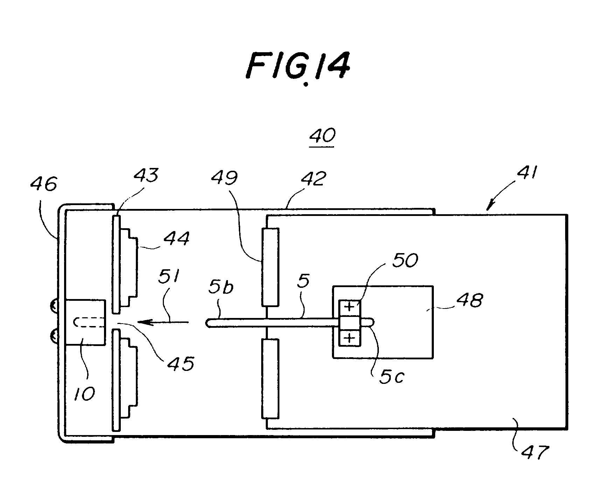

FIGS.13 and 14 illustrate the first embodiment of the electronic apparatus of the present invention. In this embodiment, the above-described heat pipe connector 10 is used. In the figures, an electronic apparatus 40 has a configuration such that a printed wiring-board assembly 41 is mounted in a shelf 42 by inserting the composite therein. A connector 44 is fixed to a back board 43. The back board 43 has a hole 45 in the center and is fitted near the back end of the shelf 42. A back cover 46 for covering an opening of the shelf 42 is made of aluminum and assembled with the heat pipe connector 10.

The printed wiring-board assembly 41 is configured such that heat-generating electronic parts 48 such as transistors, LSIs, or circuit modules are mounted on a printed board 47; the front end of the printed board along the insertion direction is provided with a connector 49; and the heat pipe 5 is fixed, at one end 5c, on the electronic parts 48 by means of hardware 50, with the other end 5b projecting away from the connector 49. The printed wiring-board assembly 41 does not have any radiating fins, and so it is smaller and lighter than the conventional board, making it easy to handle. In the space created by removing the radiating fins, other electronic parts are mounted; therefore a larger number of electronic parts are mounted on the printed board 41 than on the conventional board.

As shown in FIG.14, when the printed board 41 is inserted inside the shelf 42 in the direction 51 shown by an arrow till it reaches the terminal position, the connector 49 is coupled to the connector 44, as shown in FIG.13 and the heat pipe 5 is connected to the heat pipe connector 10 through a hole 45 as described above. As indicated by arrows 53, heat generated by the electronic parts 48 flows through the electronic parts 48→the heat pipe 5→the heat pipe connector 10→the back cover 46→the surrounding air, and is radiated outside from the back cover 46.

A front cover 52 blocks the front of the shelf 42. There is no vent hole provided on the front cover 52, and therefore the electronic apparatus 40 has better electromagnetic shielding behavior than the conventional apparatus.

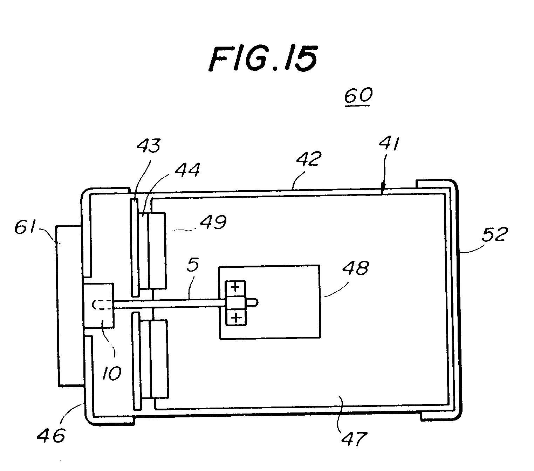

FIG.15 illustrates the second embodiment of the electronic apparatus according to the present invention. In the figure, an electronic apparatus 60 is configured such that radiating fins 61 are provided on the outer surface of the back cover 46, and the heat pipe connector 10 on the inside of the back cover 46 is fixed on the radiating fins 61. Other configurations are the same as those of the electronic apparatus 40.

The electronic apparatus 60 has better radiating efficiency than the electronic apparatus 40 of FIG.13 because of the radiating fins 61.

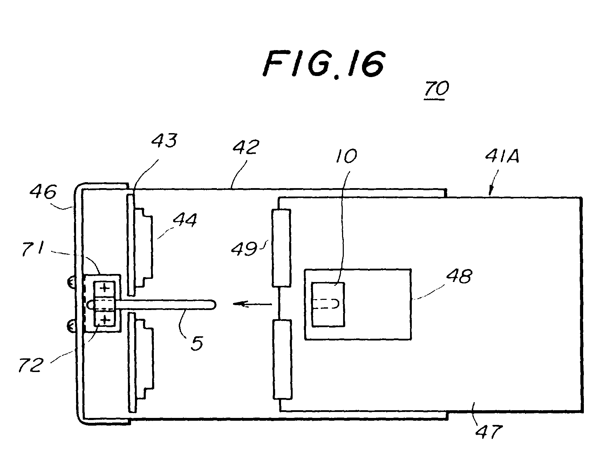

FIG.16 illustrates the third embodiment of the electronic apparatus of the present invention. In an electronic apparatus 70 in the figure, the heat pipe 5 is fixed on a bracket 71 on the back cover 46 by means of hardware 72, and projects toward the interior of the shelf 42. The heat pipe connector 10 is mounted on the electronic parts 48 in a printed composite 41A. When the printed wiring-board assembly 41A is mounted in the shelf, the heat pipe connector 10 is connected to the heat pipe 5.

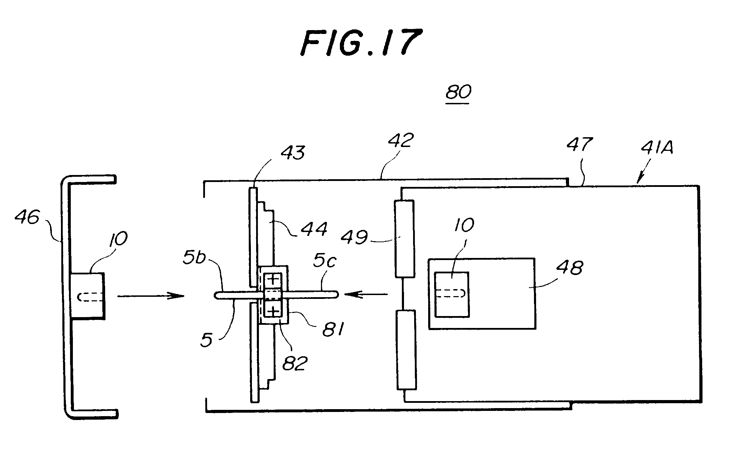

FIG.17 illustrates the fourth embodiment of the electronic apparatus of the present invention. In an electronic apparatus 80 in the figure, the center of the heat pipe 5 is fixed on a bracket 81 on the back board 43 by means of hardware 82. By fitting the back cover 46 on the heat pipe connector, the heat pipe connector 10 on the back cover 46 is connected to the end 5b of the heat pipe 5. By mounting the printed wiring-board assembly 41A in the shelf, the heat pipe connector 10 on the electronic parts 48 is connected to the end 5c of the heat pipe 5.

In the above-mentioned electronic apparatuses 70 and 80, the heat pipe is not provided in the printed wiring-board assembly 41A, thus facilitating easy handling and packing of the printed wiring-board assembly 41A. Further, in the electronic apparatus 80, this configuration of the back cover 46 makes packing the apparatus easy.

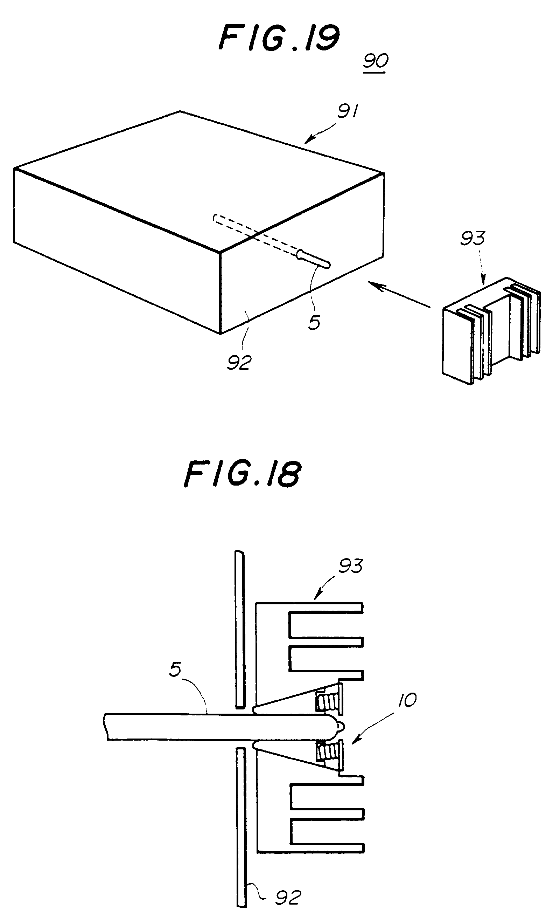

An embodiment of the radiating fins of the present invention will be now described with reference to FIGS.18 - 21.

FIG.18 illustrates an embodiment of the radiating fins. In the figure, radiating fins 93 are configured such that the above-mentioned heat pipe connector 10 is built thereinto. This figure shows a state in which the radiating fins 93 are connected to the heat pipe 5 of a table-top electronic apparatus 90 shown in FIG.19.

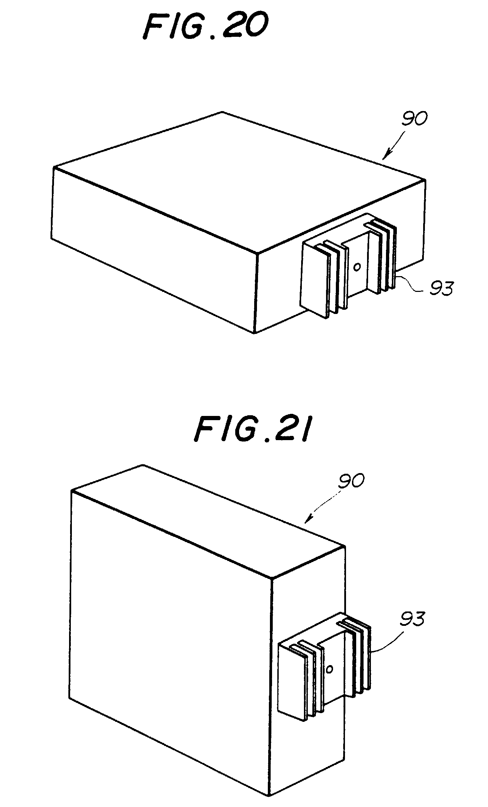

The electronic apparatus 90 is provided with the heat pipe 5 which projects from the back 92 of the shelf 91, as shown in FIG.19. Accordingly, when the radiating fins 93 are connected to the heat pipe 5 of the electronic apparatus 90 placed sideways, a state shown in FIG.20 is manifested.

When the electronic apparatus 90 is placed on end, it is desirable, in consideration of the convection effect, that the radiating fins 93 be rotated so that the fins extend vertically, as shown in FIG.21.

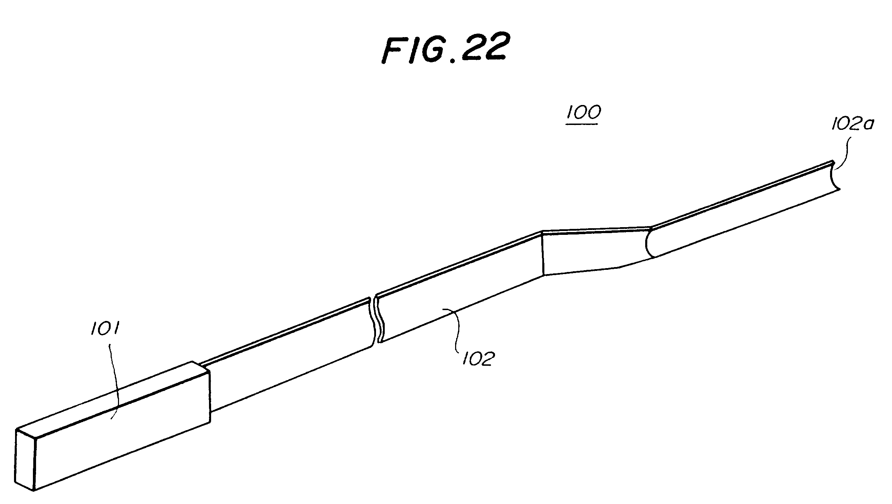

A description will now be given of a tool useful for removing the heat pipe connector 10 from the heat pipe 5, and of usage thereof, with reference to FIGS.22 - 24.

FIG.22 illustrates a tool 100. The tool 100 comprises: a handle 101 and an arm 102. The curvature of an end 102a of the arm 102 is configured to be a little larger than that of the heat pipe 5.

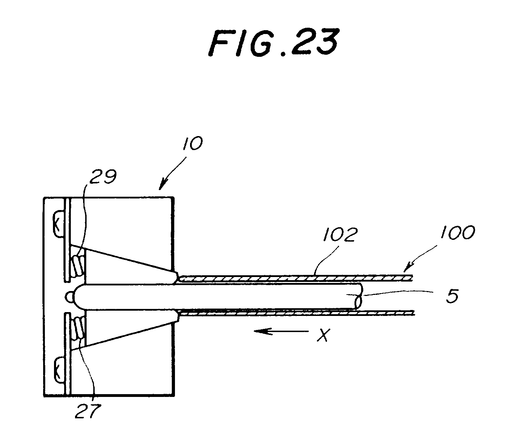

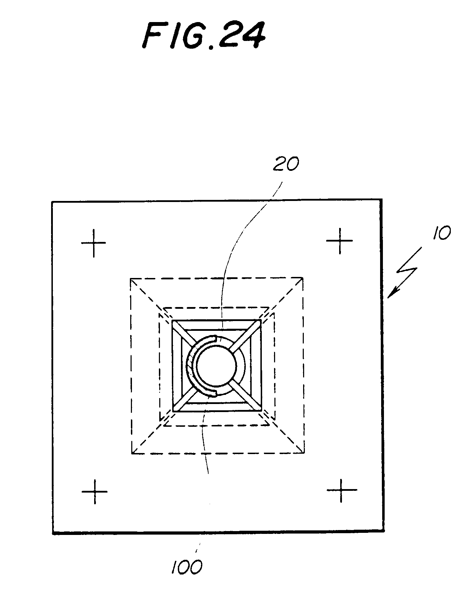

To remove the heat pipe connector 10 from the heat pipe 5, the arm 102 of the tool 100 is made to slide along the heat pipe 5 in the X direction in FIG.23 until the end 102a is in contact with some of the clamp pieces 20. As shown in FIG.24, three clamp pieces 20 are thrust by the end 102a of the arm 102 in the X direction. This results in the three clamp pieces 20 being moved in the X direction against the corresponding three springs from among the springs 27 - 30 (of which only 27 and 29 are shown in the figure), with the result that the heat pipe insertion opening 32 is slightly enlarged. As a result, the heat pipe connector 10 can be easily removed from the heat pipe 5.

In order for the tool to be able to remove the heat pipe connector from the heat pipe, it is required that the number of clamp pieces 20 thrust by the end 102a of the arm 102 be more than half the number of total clamp pieces. When there are four clamp pieces as in the above case, three of the clamp pieces 20 need to be thrust in the X direction.

In the above embodiments, the clamp pieces of the heat pipe connector are formed, for example, of aluminum or copper. It is recommendable that lubricating oil be coated on the surface of the clamp pieces, which surface forms the heat pipe insertion opening and/or on the outer surface of the heat pipe.

The present invention is not limited to the above embodiments, and various other changes and modifications may be made within the scope of the present invention.

### POSSIBLE INDUSTRIAL APPLICATION

As has been described, the heat pipe connector according to the present invention allows one end of the heat pipe inserted thereinto to be connected to the radiating and/or heat-generating portion as well as guaranteeing excellent heat convection in the connection portion. According to the electronic apparatus of the present invention, the printed wiring-board assemblies are made smaller and lighter than those of the conventional art while at the same time radiating efficiency and electromagnetic shielding behavior are improved. Moreover, the radiating efficiency of the electronic apparatus of the present invention can be improved by the radiating fins having a simple configuration, which is very useful.

## Claims

1. A heat pipe connector, comprising
a housing (11) in the form of a clamping device with a hole (14) into which a heat pipe (5) is inserted, the hole (14) being defined by a plurality of side surfaces (15 - 18),
**characterized in that**
said housing (11) has a large opening (12) and a small opening (13) which connect to form said hole (14) which is generally shaped like a quadrangular pyramid;
a plurality of clamp pieces (20₋₁ - 20₋₄) are provided which have a shape corresponding to the shape of said hole (14) when combined, said clamp pieces (20₋₁ - 20₋₄) being combined and fit within said hole (14) and forming a heat pipe insertion opening (32) at a central part thereof, said heat pipe insertion opening (32) being adapted to receive said heat pipe (5); and
a plurality of springs (27 - 30) are provided for urging said clamp pieces (20₋₁ - 20₋₄) towards the small opening (13) of said hole (14) by spring forces.

2. A heat pipe connector according to claim 1,
**characterized in that**
said clamp pieces (20₋₁ - 20₋₄) have curved surfaces, said curved surfaces (21) making close contact with an outer peripheral surface of said heat pipe (5) which is inserted into said heat pipe insertion opening (32).

3. An electronic apparatus containing at least one heat pipe connector according to claim 1 or 2,
**characterized in that**
said electronic apparatus comprises
a housing (42) having openings;
at least one printed wiring-board assembly (41, 41A) inserted through one of the openings in said housing (42) and mounted in said housing (42);
a back cover (46) for covering another one of the openings in said housing (42); and
a heat pipe (5) connecting said printed wiring-board assembly (41, 41A) and said back cover (46);
wherein at least one heat pipe connector (10) is detachably connected to one end of said heat pipe (5), said heat pipe connector (10) being fixed to said at least one printed wiring-board assembly (41, 41A) and said back cover (46).

4. An electronic apparatus according to claim 3,
**characterized in that**
said heat pipe connector (10) being fixed to said one end of said heat pipe (5) is fixed to said back cover (46), and the other end of said heat pipe (5) is fixed to said printed wiring-board assembly (41).

5. An electronic apparatus according to claim 4,
**characterized in that**
said back cover (46) includes radiator fins (61).

6. An electronic apparatus according to claim 3,
**characterized in that**
said heat pipe connector (10) being fixed to said one end of said heat pipe (5) is fixed to said printed wiring-board assembly (41), and the other end of said heat pipe (5) is fixed to said back cover (46).

7. An electronic apparatus according to claim 3,
**characterized by**
a back board (43) which is inserted between said printed wiring-board assembly (41A) and said back cover (46) within said housing (42), a central portion of said heat pipe (5) being fixed to said back board (43).

8. An electronic apparatus containing at least one heat pipe connector according to claim 1 or 2,
**characterized in that**
said electronic apparatus comprises
a housing (91);
a heat pipe (5) having one end connected to a heat generating portion within said housing (91) and another end projecting from said housing (91); and
a radiator fin structure (93) having said heat pipe connector (10) which is detachably connected to the other end of said heat pipe (10).

9. An electronic apparatus according to claim 8,
**characterized in that**
said radiator fin structure (93) is rotatably connected with respect to said heat pipe (5).

10. A Radiator fin structure containing at least one heat pipe connector according to claim 1 or 2,
**characterized in that**
said radiator fin structure comprises
a fin member having a plurality of fins (93); and
said heat pipe connector (10) which is fixed to said fin member and detachably connected to one end of a heat pipe (5).

11. A radiator fin structure according to claim 10,
**characterized in that**
said fin member is rotatably connected with respect to said heat pipe (5).

## Patentansprüche

1. Verbindungsstück für ein Wärmerohr, umfassend
ein wie eine Klemmvorrichtung geformtes Gehäuse (11) mit einem Loch (14), in welches ein Wärmerohr (5) eingeführt ist, wobei das Loch (14) durch eine Vielzahl von Seitenflächen (15-18) definiert ist,
**dadurch gekennzeichnet,**
daß das Gehäuse (11) eine große Öffnung (12) und eine kleine Öffnung (13) aufweist, welche miteinander verbunden das Loch (14) bilden, welches im wesentlichen die Form einer viereckigen Pyramide besitzt,
daß eine Vielzahl von Klemmteilen (20₋₁ - 20₋₄) vorhanden ist, deren Form im zusammengesetzten Zustand der Form des Loches (14) entspricht, wobei die Klemmteile (20₋₁ - 20₋₄) zusammengesetzt und in das Loch (14) eingepaßt sind und an einem mittleren Bereich des Loches (14) eine Einführöffnung (32) für das Wärmerohr (5) bilden, und
eine Vielzahl von Federn (27-30) vorhanden sind, um die Klemmteile (20₋₁ - 20₋₄) gegen die kleine Öffnung (13) des Loches (14) mit Hilfe von Federkräften zu drücken.

2. Verbindungsstück für ein Wärmerohr nach Anspruch 1,
**dadurch gekennzeichnet,**
daß die Klemmteile (20-1 - 20-4) gekrümmte Oberflächen (21) aufweisen, die in einem engen Kontakt mit einer äußeren Oberfläche des Wärmerohrs (5), welches in die Einführöffnung (32) für das Wärmerohr eingeführt ist, stehen.

3. Elektronische Vorrichtung mit mindestens einem Verbindungsstück für ein Wärmerohr nach Anspruch 1 oder 2,
**dadurch gekennzeichnet,**
daß die elektronische Vorrichtung umfaßt
ein Gehäuse (42) mit Öffnungen,
mindestens eine gedruckte Leiterplattenanordnung (41, 41A), die durch eine der Öffnungen in das Gehäuse (42) eingesetzt und in dem Gehäuse (42) befestigt ist,
eine Rückabdeckung (46) zum Abdecken einer weiteren Öffnung des Gehäuses (42), und
ein Wärmerohr (5), welches die gedruckte Leiterplattenanordnung (41, 41A) und die Rückabdeckung (46) verbindet,
wobei mindestens ein Verbindungsstück (10) für ein Wärmerohr lösbar mit einem Ende des Wärmerohrs (5) verbunden und an der mindestens einen gedruckten Leiterplattenanordnung (41, 41A) sowie der Rückabdeckung (46) befestigt ist.

4. Elektronische Vorrichtung nach Anspruch 3,
**dadurch gekennzeichnet,**
daß das Verbindungsstück (10) für ein Wärmerohr, welches mit dem einen Ende des Wärmerohrs (5) verbunden ist, an der Rückabdeckung (46) und das andere Ende des Wärmerohrs (5) an der gedruckten Leiterplattenanordnung (41) befestigt ist.

5. Elektronische Vorrichtung nach Anspruch 4,
**dadurch gekennzeichnet,**
daß die Rückabdeckung (46) Kühlrippen (61) aufweist.

6. Elektronische Vorrichtung nach Anspruch 3,
**dadurch gekennzeichnet,**
daß das Verbindungsstück (10) für ein Wärmerohr, welches mit dem einen Ende des wärmeleitenden Rohrs (5) verbunden ist, an der gedruckten Leiterplattenanordnung (41) und das andere Ende des Wärmerohrs (5) an der Rückabdeckung (46) befestigt ist.

7. Elektronische Vorrichtung nach Anspruch 3,
**gekennzeichnet durch**
eine Rückplatte (43), die zwischen der gedruckten Leiterplattenanordnung (41A) und der Rückabdeckung (46) innerhalb des Gehäuses (42) eingesetzt ist, wobei ein mittlerer Bereich des Wärmerohrs (5) an der Rückplatte (43) befestigt ist.

8. Elektronische Vorrichtung mit mindestens einem Verbindungsstück für ein Wärmerohr nach Anspruch 1 oder 2,
**dadurch gekennzeichnet,**
daß die elektronische Vorrichtung umfaßt
ein Gehäuse (91),
ein Wärmerohr (5), dessen eines Ende mit einem wärmeerzeugenden Abschnitt innerhalb des Gehäuses (91) verbunden ist und dessen anderes Ende von dem Gehäuse (91) hervorsteht, und
eine Kühlrippenanordnung (93), die das Verbindungsstück (10) für ein Wärmerohr aufweist, welches lösbar mit dem anderen Ende des Wärmerohrs (10) verbunden ist.

9. Elektronische Vorrichtung nach Anspruch 8,
**dadurch gekennzeichnet,**
daß die Kühlrippenanordnung (93) drehbar bezüglich des Wärmerohrs (5) angeordnet ist.

10. Kühlrippenanordnung mit mindestens einem Verbindungsstück für ein Wärmerohr nach Anspruch 1 oder 2,
**dadurch gekennzeichnet,**
daß die Kühlrippenanordnung umfaßt
ein Kühlrippenteil mit einer Vielzahl von Kühlrippen (93), und
das Verbindungsstück (10) für ein Wärmerohr, welches an das Kühlrippenteil befestigt und lösbar mit einem Ende eines Wärmerohrs (5) verbunden ist.

11. Kühlrippenanordnung nach Anspruch 10,
**dadurch gekennzeichnet,**
daß das Kühlrippenteil drehbar bezüglich des Wärmerohrs (5) angeordnet ist.

## Revendications

1. Raccord de tube de transfert de chaleur, comprenant:
un corps (11) sous la forme d'un dispositif de serrage muni d'un trou (14) dans lequel on insère un tube (5) de transfert de chaleur, le trou (14) étant défini par une pluralité de surfaces latérales (15-18), caractérisé en ce que
ledit corps (11) comporte une grande ouverture (12) et une petite ouverture (13) qui sont raccordées de manière à former ledit trou (14) qui a, d'une façon générale, la forme d'une pyramide à base quadrangulaire;
une pluralité de pièces de serrage (20₋₁-20₋₄) sont prévues , lesquelles ont une forme correspondant à la forme dudit trou (14) quand elles sont combinées, lesdites pièces de serrage (20₋₁-20₋₄) étant combinées et montées à l'intérieur dudit trou (14) et formant une ouverture (32) d'insertion de tube de transfert de chaleur dans leur partie centrale, ladite ouverture (32) d'insertion de tube de transfert de chaleur étant adaptée pour recevoir ledit tube (5) de transfert de chaleur; et
une pluralité de ressorts (27-30) sont prévus pour pousser lesdites pièces de serrage (20₋₁-20₋₄) vers la petite ouverture (13) dudit trou (14) à l'aide de forces élastiques.

2. Raccord de tube de transfert de chaleur selon la revendication 1, caractérisé en ce que lesdites pièces de serrage (20₋₁-20₋₄) ont des surfaces courbées, lesdites surfaces courbées (21) étant en contact étroit avec la surface périphérique extérieure dudit tube (5) de transfert de chaleur qui est inséré dans ladite ouverture (32) d'insertion de tube de chaleur.

3. Appareil électronique contenant au moins un raccord de tube de transfert de chaleur selon la revendication 1 ou 2, caractérisé en ce que ledit appareil électronique comprend:
un corps (42) comportant des ouvertures;
au moins un ensemble (41, 41A) formant carte de circuits imprimés, inséré à travers une des ouvertures dudit corps (42) et monté dans ledit corps (42); et
un couvercle arrière (46) destiné à recouvrir une autre des ouvertures dudit corps (42); et
un tube (5) de transfert de chaleur raccordant ledit ensemble (41,41A), formant carte de circuits imprimés, et ledit couvercle arrière (46);
au moins un raccord (10) de tube de transfert de chaleur étant raccordé, de façon séparable, à une première des extrémités dudit tube (5) de transfert de chaleur, ledit raccord (10) de tube de transfert de chaleur étant fixé audit ensemble (41, 41A) formant carte de circuits imprimés, au nombre d'au moins un, et audit couvercle arrière (46).

4. Appareil électronique selon la revendication 3, caractérisé en ce que ledit raccord (10) de tube de transfert de chaleur, qui est fixé à ladite première extrémité dudit tube (5) de transfert de chaleur, est fixé audit couvercle arrière (46), et la seconde extrémité dudit tube (5) de transfert de chaleur est fixée audit ensemble (41) formant carte de circuits imprimés.

5. Appareil électronique selon la revendication 4, caractérisé en ce que ledit couvercle arrière (46) comprend des ailettes (61) de radiateur.

6. Appareil électronique selon la revendication 3, caractérisé en ce que ledit raccord (10) de tube de transfert de chaleur qui est fixé à ladite première extrémité dudit tube (5) de transfert de chaleur est fixé audit ensemble (41) formant carte de circuits imprimés et la seconde extrémité dudit tube (5) de transfert de chaleur est fixée audit couvercle arrière (46).

7. Appareil électronique selon la revendication 3, caractérisé par un plaque arrière (43) qui est insérée entre ledit ensemble (41A), formant carte de circuits imprimés, et ledit couvercle arrière (46) à l'intérieur du corps (42), une partie centrale dudit tube (5) de transfert de chaleur étant fixée à ladite plaque arrière (43).

8. Appareil électronique contenant au moins un raccord de tube de transfert de chaleur selon la revendication 1 ou 2, caractérisé en ce que ledit appareil électronique comprend:
un corps (91);
un tube (5) de transfert de chaleur dont une des extrémités est raccordée à une partie génératrice de chaleur à l'intérieur dudit corps (91) et dont l'autre extrémité fait saillie dudit corps (91); et
une structure (93) d'ailettes de radiateur comportant ledit raccord (10) de tube de transfert de chaleur qui est raccordé, de façon séparable, à la seconde extrémité dudit tube (10) de transfert de chaleur.

9. Appareil électronique selon la revendication 8, caractérisé en ce que ladite structure (93) d'ailettes de radiateur est montée de façon tournante par rapport dudit tube (5) de transfert de chaleur.

10. Structure d'ailettes de radiateur contenant au moins un raccord de tube de transfert de chaleur selon la revendication 1 ou 2, caractérisée en ce que ladite structure d'ailettes de radiateur comprend un élément à ailettes comportant une pluralité d'ailettes (93); et
ledit raccord (10) de tube de transfert de chaleur qui est fixé audit élément d'ailette et raccordé, de façon séparable, à une des extrémités d'un tube (5) de transfert de chaleur.

11. Structure d'ailettes de radiateur selon la revendication 10, caractérisé en ce que ledit élément à ailettes est monté de façon tournante par rapport audit tube (5) de transfert de chaleur.
